(19) Europäisches Patentamt
European Patent Office
Office européen des brevets

(11) Publication number: **0 160 944 B1**

(12) **EUROPEAN PATENT SPECIFICATION**

(45) Date of publication of patent specification: **29.07.92** (51) Int. Cl.[5]: **G06F 15/60**

(21) Application number: **85105412.2**

(22) Date of filing: **03.05.85**

# (54) System function simulation method and apparatus.

(30) Priority: **11.05.84 JP 92870/84**

(43) Date of publication of application:
**13.11.85 Bulletin 85/46**

(45) Publication of the grant of the patent:
**29.07.92 Bulletin 92/31**

(84) Designated Contracting States:
**DE FR GB**

(56) References cited:

**COMMUNICATIONS OF THE ACM, vol. 16, no. 8, August 1973, pages 474-481; D. MISUNAS: "Petri nets and speed independent design"**

**PROCEEDINGS OF DISTRIBUTED COMPUTING, Washington, 23rd-25th September 1980, pages 55-62, IEEE, New York, US; H. TAKENOUCHI et al.: "Parallel processing simulator for network systems using multi-microcomputer"**

(73) Proprietor: **HITACHI, LTD.**
**6, Kanda Surugadai 4-chome**
**Chiyoda-ku, Tokyo 100(JP)**

(72) Inventor: **Nakano, Toshihiko**
**1-33-2, Nishinarusawa-cho**
**Hitachi-shi Ibaraki-ken(JP)**
Inventor: **Hayashi, Toshihiro**
**2455-806, Nakamaru Kubo-cho**
**Hitachi-shi Ibaraki-ken(JP)**
Inventor: **Nogi, Kenroku**
**Hitachi dai 2 Kyoshin-ryo**
**4-14-6,Higashi-koigakubo**
**Kokubunji-shi Tokyo(JP)**
Inventor: **Mori, Kiyomi**
**4-4-9, Suwa-cho**
**Hitachi-shi Ibaraki-ken(JP)**

(74) Representative: **Strehl, Schübel-Hopf, Groening**
**Maximilianstrasse 54 Postfach 22 14 55**
**W-8000 München 22(DE)**

EP 0 160 944 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

#### Field of the Invention

The present invention relates to a function simulation method and an apparatus therefor and, more particularly, to simulation method and apparatus which are suitable for function simulation of an asynchronously and parallel operable distributed system. In this simulation method, moreover, a Petri net model conducts the simulation of a function to transform the input data into the output data of the system.

#### Description of the Prior Art

There has not yet been established a method which is suitable for simulating the functions of an asynchronous self-controlled distributed system rather than a synchronous system.

The Petri net, a numerical model for describing and analyzing the flow and control of data in an asynchronous, parallel system, was proposed by Petri in 1962. The Petri net model has been widely used and studied. See "Special Feature 'Putting Petri nets to Work'" (by Tilak Agerwala, IEEE, Computer, December 1979, pp. 85 to 94) and "Petri Nets and Speed Independent Design" (by David Misunas, Communications of the ACM, Vol.16, No.8, August 1973).

Petri nets are expressed by an oriented graph which has two kinds of nodes, i.e., places and transitions. Arcs are oriented from the places to the transitions or vice versa. The places have tokens, and the arrangement of these tokens are called the "markings" of the Petri net model, the first of which is called the "initial marking" of the Petri net.

When a system is to be simulated by a Petri net model, the passage of the token through the transition means that data are processed and output. The token indicates data movement, but it does not indicate which data structure has been transformed nor does it indicate what structure it has been transformed into. This has the obvious disadvantage that data transforming procedures which are crucial in the simulation of functions are left undisclosed.

### SUMMARY OF THE INVENTION

An object of the present invention is to simulate function of an asynchronous and parallel system with a Petri net model.

Another object of the present invention is to provide a simulation system which can track changes in data structure as the simulation proceeds.

These objects are solved with the method of claim 1 and the apparatus of claim 3

### BRIEF DESCRIPTION OF THE DRAWINGS

Fig. 1 is a block diagram showing the case in which a plurality of cash dispensers are coupled to one host computer;

Fig. 2 is a diagram showing the processing of the cash dispenser and the host computer with a Petri net model;

Fig. 3 is a detailed diagram showing a portion of Fig. 2;

Fig. 4 is a block diagram showing the whole structure of the present invention;

Fig. 5 shows the construction of the whole structure table of Fig. 4;

Fig. 6 shows the construction of a system structure table of Fig. 4;

Fig. 7 shows the construction of a data structure table of Fig. 4;

Fig. 8 is a simulation processing flow chart in the system simulation system;

Figs. 9(a) to (g) exemplify transfer of information between the terminals and the host computer and the data structures;

Fig. 10 shows the coupling between the host computer and the terminal unit, i.e., the cash dispenser through points in the Petri net model;

Fig. 11 shows an example of the whole structure table;

Fig. 12 shows a system structure table according to the examples of Fig. 9;

Fig. 13 likewise shows an example of the data structure table;

Fig. 14 exemplifies a detailed diagram of the host computer which is expressed by a Petri net model;

Figs. 15(a) to (d) and Figs. 16(a) to (c) exemplify the displays of the simulation procedures and the procedures for movement of tokens, respectively; and

Figs. 17(a) and (b) exemplify the token flags in the functional simulation places.

### DESCRIPTION OF THE PREFERRED EMBODIMENTS

The present invention aims to comprehend not only the movements of tokens but also their data transformation procedures and to simulate asynchronous, parallel operation. An example of such a system is considered here where a plurality of cash dispensers for depositing and dispensing money by means of credit cards are coupled to a host computer.

Fig. 1 is a block diagram showing the structure in which cash dispensers are coupled to a host computer. This is an example in which a number n of terminal units are connected to the host computer through communication lines. The relationship between one terminal unit and the host computer is expressed by the Petri net models, as shown in Fig. 2. Fig. 2 shows the case in which money is dispensed by using cash cards.

In Fig. 2, reference letters $T_{CD1}$, $T_{CD3}$, $T_{CD5}$ and $T_{CD7}$ indicate transition, and letters $P_{CD2}$, $P_{CD4}$ and $P_{CD6}$ indicate places, both being located at the side of the cash dispenser. Letters $P_{C1}$, $P_{C2}$ and $P_{C3}$ indicate the communication line places; letters $T_{h3}$ and $T_{h4}$ the host computer transition; and letters $P_{h1}$ and $P_{h2}$ the host computer places.

Let us consider the on-line system of a bank which comprises a host computer and cash dispensers so that information such as account numbers or amount of cash payment is exchanged between host computer and dispenser. The host computer computes and executes balance renewal, and the host dispensers verify cash cards and accept and dispense cash independently of one another.

The processing flow will now be schematically explained. The cash card is received at transition $T_{CD7}$; the card number is read at the place $P_{CD5}$; and the cash card is verified at the transition $T_{CD5}$. A cash payment amount demand signal is generated at the place $P_{CD4}$; payment is received at transition $T_{CD3}$; and the cash payment amount is transmitted to the host computer through the place $P_{CD5}$. From the transition $T_{CD5}$, the account number is transmitted through the place $P_{C2}$ to the host computer. At transition $T_{h4}$, the host computer determines the cash payment amount, the account number and the balance (at $T_{h4}$) after the cash is dispensed, so as to certify the balance (at $P_{h1}$). When predetermined conditions are satisfied, the host computer transmits the cash payment amount through the place $P_{C1}$ to the cash dispenser so that the cash is dispensed (at $T_{CD1}$).After a series of these processings, the cash dispenser then allows a subsequent card reception demand signal (at $P_{CD2}$).The place $P_{h2}$ at the host computer indicates maintaining data, i.e., the cash payment amount. Letters $P_{C1}$ to $P_{C3}$ indicate memory buffers which can belong to terminals or to the host computer.

Fig. 3 shows the transition $T_{CD5}$ of Fig. 2 in detail. $T_{cd1}$ indicates reading the user I.D.; $T_{cd2}$ indicates input of user I.D.; $T_{cd3}$ indicates verification of user I.D.; $T_{cd4}$ denotes an error message indicating wrong user I.D.; $P_{cd1}$ and $P_{cd2}$ denote user I.D.; $P_{cd3}$ denotes a place having an input demand. $P_{CD4}$ indicates the place which is equivalent to $P_{CD4}$ of Fig. 2 but contains oriented graphic expressions for the transition $T_{cd4}$.

Fig. 4 is a block diagram of the structure of an embodiment of the present invention.

A whole structure table 31, a system structure table 32 and a data structure table 33 are mounted on a memory unit (Me), which is stored with the data concerning the system to be simulated. A system determining program 34 reads in the simulation initializing point in the target system, which is determined by an input-output device so as to prompt the simulation system 30.

An information input program 35 displays the information required of the simulation system as the input demand in the input-output device 36 and inputs the necessary information from that device to the simulation system 30. This simulation system 30 simulates, when it is informed of the target system and the simulation initialization point from the system determining program 34, the system which is stored in the whole structure table 31, the system structure table 32 and the data structure table 33, to display the procedures in the input-output device 36.

Next, the structural components of Fig. 4 will be described. The whole structure table 31 is shown in Fig. 5. A process distinguishing name, hereafter called the "process name" is used in constructing the system. This is stored in a memory area 4a ($PR_1$ to $PR_i$). Here, i indicates the number of processes which are required for expressing the target system. In the example of Fig. 2, the memory area corresponds to the number of terminal units n, the cash dispensers, and the host computer.

Now, if it is assumed that information from the host computer of Fig. 2 is stored in the place $PR_2$, and that information from the cash dispenser of Fig. 2 is stored in the place $PR_i$, then, process name information related to memory areas 4b, 4c and 4d is stored in places $PR_2/PR_i$ of Fig. 5.

The memory area 4b, ($FNK_{1,1,1}$ to $FNK_{i,i,j}$) for the process name contains the function names, which are to be input from the line processes and output to the column processes. Here, i has a meaning similar to the aforementioned one. j indicates the total number of functions belonging to the column processes, which are to be used by the line processes.

The memory area 4c (i.e., $IDS_{1,1,1}$ to $IDS_{i,i,j}$) for the input data structure names corresponds to the function name memory area and contains the data structure names which are to be input into the functions stored in the function name memory area. Here, i and j have meanings similar to the aforementioned ones.

The memory area 4d (i.e., $ODS_{1,1,1}$ to $ODS_{i,i,j}$) for the output data structure names contains the data structure names from which are to be output from the functions stored in the function name memory area. Here, i and j have meanings similar to the aforementioned ones.

The system structure table 32 is shown in Fig. 6. The memory area 5a (i.e., $PF_1$ to $PF_i$) contains the function or process name. Here, i indicates the total number of functions and processes which are required of the target system as a whole.

A memory area 5b (i.e., $TM_1$ to $TM_m$) for transition names is stored with recognition names for distinguishing transitions. Here, letter m indicates the number of transitions required to express the system to be simulated.

A memory area 5c (i.e., $NF_1$ to $NF_m$) for function names corresponds to the transition name memory area and contains the names of the functions to be conducted by the transitions. Here, m has a meaning similar to the aforementioned one.

A memory area 5d (i.e., $NFF_1$ to $NFF_m$) for flags, which determine the details of function in the step corresponds to the function name memory and contains information as to whether the functions of the names of the respective function name memory areas are detailed by the system structure table. Here, m has a meaning similar to the aforementioned one.

A memory area 5e (i.e., $WSF_1$ to $WSF_m$) for flags, which determine whether action is requested in the next step, contains information as to whether the token has moved to another system structure table and whether the system is awaiting its return. Here, m has a meaning similar to the aforementioned one.

A memory area 5f (i.e., $PM_1$ to $PM_n$) for place names contains identifiers (hereafter called place names) which denote the standby location of the token. Here, n indicates the number of place names required to represent the target system.

A memory area 5g (i.e., $DSM_1$ to $DSM_n$) for data structure names contains the names of the data structures which are to be held by the token standing by in said place. Here, n has a meaning similar to the aforementioned one.

A memory area 5h (i.e., $PTM_1$ to $PTM_n$) for flags which determine whether the present step is a token step corresponds to the place name memory area and contains data indicating whether the token is present in said place. Here, n has a meaning similar to the aforementioned one.

A memory area 5 ℓ (i.e., $TFM_1$ to $TFM_n$) for the relationship between places and transitions corresponds to the place name memory area and the transition name memory area and contains data indicating the relationship between places and transitions. The relationships are those in which the token moves from place to transition, those in which the token moves from transition to place, and those in which there is no relationship between transition and token. Here, n and m have meanings similar to the aforementioned ones.

A memory area 5k (i.e., $TTM_{1,1}$ to $TTM_{n,m}$) for token movement data corresponds to the memory area for the relationship between places and transitions and contains data indicating which transition the token moves to in case the token can move from a place to a plurality of transitions. Here, n and m have meanings similar to the aforementioned ones.

Next, the data structure table 32 is shown in Fig. 7. A memory area 6a (i.e., $DSE_1$ to $DSE_i$) contains data structure names. Here, i indicates the number of the data structure names required to represent the system to be simulated.

A memory area 6c ($DUE_1$ to $Due_k$) for subordinate data structure names corresponds to the data structure name memory area and contains the subordinate data structure names for data structure names stored in the data structure name memory area. Here, k indicates the total number of subordinate data structure names for the data structure names.

A related memory area 6b (i.e., $DRM_1$ to $DRM_j$) corresponds to the data structure name memory area and contains data indicating how the data structure names are related to the subordinate data structure names. Here, J indicates the number of relationships which are required for preparing the data structure to represent the system to be simulated.

The simulation system 30 containing the processor executes the process in the flow chart shown in Fig. 8.

The operation of the present simulation system 30 will be described by considering a specific example, the system which is shown in Fig. 9. Fig. 9(a) shows a simple system structure, the host computer and a cash dispenser coupled to the host computer. The process names indicate the relationship between the cash dispenser and the host computer. The data structure names to be transmitted from the cash dispenser to the host computer correspond to the cash payment data pulse train, and the data structure names to be transmitted from the host computer to the cash dispenser correspond to the cash payment amount. The host computer executes the functions to input, transform and output the data structures from the cash dispenser, namely, the functions for balance verification.

Figs. 9(b) and (c) show the data structures to flow between the processes. For example, the relationships between the data structure name "cash payment data pulse train" and the cash payment data are expressed by a pulse train.

Figs. 9(d) to (f) show the internal structures of the functions. Fig. 9(g) shows the data structure of a portion of the data structure names shown in Figs. 9(d) to (g). Letters P and T indicate places and transitions, respectively.

In Fig. 9(a), the system is constructed of processes called the "cash dispenser" and the "host computer". The data called the "cash payment data pulse train" and the "cash payment amount" are transferred between the cash dispenser and the host computer. Fig. 9(b) shows the structure of the data structure name "cash payment data pulse train" to be transmitted from the cash dispenser to the host computer, and shows that the "cash payment data pulse train" is given as the pulse train in sequence with the cash payment data composed of the account number and the cash payment amount.

Fig. 9(d) shows the Petri net model for the cash dispenser. The $P_{CD2}$, $P_{CD4}$, $P_{CD6}$, $P_{C1}$, $P_{C2}$ and $P_{C3}$ indicate places, and the $T_{CD1}$, $T_{CD3}$, $T_{CD5}$, $T_{CD7}$ and $T_{h4}$ indicate the transitions.

The function assigned to the transition $T_{h4}$, i.e., the "the host computer: balance certification" does not indicate execution of the present function in the cash dispenser; it indicates the attainment of the resultant data by sending the data to the function of the "host computer", i.e., the "balance verification". In other words, it is shown that the data are transferred between these processes during the execution of the present function.

The simulation system 30 conducts, at step 71 of Fig. 8, the initial determination of the whole structure table, the system structure table, the data structure table and the tokens, which are required for the simulations, in accordance with the system determining program 34 of Fig. 4. The whole structure table is prepared on the basis of the information shown in Fig. 9(a). Here, the whole structure of the present embodiment is shown in Fig. 10. The host computer is coupled to the cash dispensers. The function of the host computer, i.e., the "balance verification" is also used in the cash dispensers. Moreover, this function is executed when the tokens are at the place ($P_{h1}$) called "balance", the place ($P_{C1}$) called "cash payment amount", and at the place $P_{C2}$ called "account number". If one cash dispenser makes use of the "balance verification" of the host computer, the other cash dispensers are made to wait because the tokens cannot set at "balance certification", "cash payment amount" and "account number".

The whole structure table reflecting the information of Fig. 9(a) is shown in Fig. 11. The system structure table is prepared on the basis of the information shown in Figs. 9(d) to (f). The system structure table reflecting the information of Fig. 9(d) is prepared in accordance with Fig. 6 and is shown in Fig. 12. Figs. 9(e) and (f) are also prepared in a similar manner (although not described in the present example). In Fig. 12, the "token present" flag memory area 5h is set at "absence" (0), and the action requesting state flag memory area 5e is set at "non-stand-by" (0). The data structure table is prepared on the basis of the information shown in Figs. 9(b), (c) and (g). The data structure table reflecting the information of Figs. 9(b), (c) and (g) is shown in Fig. 13. Moreover, one or more tokens are set at the start position of the simulation at a process unit. The initial data thus far described are determined.

An example of simulation will be described in the following where tokens are set at $P_{CD6}$ of Fig. 9-(d) and at $P_{h1}$ of Fig. 9(e).

At a step 72 of Fig. 8, all the "token present" flag memory areas of all the system structure tables are examined to determine all the places where the tokens are present. The present example corresponds to the cases in which the tokens are input from the input-output device 36 and the $P_{CD6}$ of the cash dispenser and the $P_{h1}$ of the host computer.

At a step 73 of Fig. 8, the respective tokens identified at step 72 are judged as to the relationships between places and transitions of the system structure table. It is determined whether the number of "removal from place to the transition" relationships is two or more, one or none. In the case of the present example, there exists the transition of removal from the "$T_{CD5}$ of the $P_{CD6}$ of the cash dispenser" and the "$T_{h4}$ of the $P_{h1}$ of the host computer".

At step 74, it is determined in accordance with the result revealed at the step 73 whether the function to be executed next can be simulated. In case the number of the relationships examined at the step 73 and present between the places and the transitions is two or more, the destination of the token cannot be determined, but step 75 is executed. In the present example, the token at the $P_{CD6}$ of the cash dispenser can be moved to the transition $T_{CD5}$ whereas the token at the $P_{h1}$ of the host computer can be removed to the transition $T_{h4}$ so that the step 77 is conducted.

At a step 75, the content of the token removing memory area, which contains the relationship of the "removal from place to transition" is displayed on the input-output device. Moreover, the transition to which the token is removed is selected.

At step 76, the transition in the place where the token is removed is input from the input device of the input-output device 36 by the use of the information input program 35.

At a step 77, synchronization of the destination transition found at steps 74 and 76 is confirmed. For the destination transition which has been identified at steps 74 and 76, as shown in Fig. 6, a search determines that all "token present" flags corresponding to place names relating to the "removal from place to transition" indicate "presence", and that all token presence flags corresponding to the place names relating to the "removal from the transition to the place" indicate "absence". If the token removal condition memory area is present at that time, it is searched to find whether the destination transition has been selected at step 76.

For tokens having no destination transition, all place name token presence flags stored in the system structure table, in which the destination tokens are present, but have no relationship to the "removal from place to transition" are checked. Then, it is assumed that synchronization has been done for "presence", but not for "absence".

At a step 78, if the results from step 77 reveal that all the token presence flags indicate "presence", that the token is absent from the destination and that the removal condition of the token is satisfied, it is determined that synchronization has been taken in case the destination transition is selected, and the operation advances to step 79. Otherwise, the operation is returned to step 72. In the present example, both tokens are synchronized so as to be subjected to step 79.

At this step 79, if the destination transition of the token of Fig. 6 to be removed is present, the detailed presence flag memory area 5d of the function of the transition is examined. In the case of the state of the "absence of the detail of the function", the data of the place name token presence flag memory area relating to the "removal from place to transition" of the related memory area for place and transition of the destination transition are determined at "absence", whereas the data for the place name token presence flag memory area 5 ℓ relating to "removal from the transition to the place" are determined at "presence". In the memory area 5 ℓ: the value "0" means no relationship; that the value "1" means the removal from the place to the transition; and that the value "-1" means the removal from the transition to the place.

Here, the column of the intersections of $P_{CD6}$ - $T_{CD5}$ in Fig. 12, for example, will be described in the following. An arc is present from the place $P_{CD6}$ to the transition $T_{CD5}$. This is expressed at [1] in the upper lines. There is no special condition at this time. This is expressed at [-] in the lower lines. In the column of the intersections of $P_{CD6}$ - $T_{CD7}$, the value [-1] in the upper lines indicates that an opposite arc is present, and the value [1] in the lower lines indicates that no special condition is present.

For the condition "details of the function are determined", the action requesting condition flag memory area 5e corresponding to said transition is set at "1", indicating that "the token is being removed to another system structure table", to examine the system structure table which is coincident with the discriminator stored in the "function name or process name memory area" 5a of that system structure table coinciding with the function name of the function name memory area 5c. The coinciding system structure table will be called the "destination system structure table", which is the system structure table in which said token is present.

The memory area 5e is set at "0" in the absence of the request.

In the place-transition relating memory area 5ℓ of the destination system structure table, it is possible to determine the data structure name belonging to the place name to which the token can be removed from the destination transition.

In the data structure name memory area of the destination system structure table, one coincident with said data structure name is examined, and the flag for the "token present" flag memory area corresponding to the coincident data structure name is set at "present".

In the system structure table, the "token present" flag indicating the token to be removed is set at the "absent".

In case the destination transition of the token to be removed is absent, both the function name of the "function name or process name memory area" of the system structure table, in which said token to be removed is present, (which will be called the "destination system structure table"), and the data structure name corresponding to the name of the place, in which said token is present, are examined (which will be called the "destination function name and destination data structure name").

Next, the function name memory area of another system structure table is examined to find one the with the destination function name. If a matching name is found, it is determined whether or not the data of the action requesting state flag memory area corresponding to the coincident function name are in the state where "the token is being removed to another system structure table". If not matching name is found, the search continues. If a matching name is found, the data for the action requesting state flag memory area are set at "non-stand-by", and the "token present" flag memory area for the place name having the data structure name coincident with the destination data structure name is set at "present" whereas the token presence flag indicating the destination token of the destination system structure table is set at "absent".

At step 80, the input data structure and the output data structure of the transition, through which the token has passed, are prepared. More specifically, the data structures, which have been held by the tokens present in all the places of the place names relating to the transition names at the previous step, are prepared with reference to Fig. 7. In other words, the relationships between the data structure names and the subordinate data structure names, and the subordinate data structure names are examined in view of the data structure table by using as keys, those data structure names which correspond to the place names for preparing the data structure. The subordinate data structure names attained as a result of the examinations are further examined in a similar manner. These examinations are repeated when examination has revealed that no subordinate data structure names are present.

At step 81, the execution procedures for the aforementioned functions are displayed on the input-output device 36. At the end of the present step, the operation is returned to step 72.

Fig. 14 shows an example a built-in Petri net model in the transition $T_{h4}$ of the host computer. $T_{h41}$, $T_{h42}$, $T_{h43}$ and $T_{h44}$ indicate transitions, and $P_{h3}$ indicates the place where the result of the account number certification ($T_{41}$) is present. As a result, the token is removed to transition $T_{43}$ if the account is absent and to transition $T_{42}$ if it is present.

Transition $T_{h4}$ indicated by a single-dotted line in Fig. 14 is the host computer seen from the terminal unit side and can be considered a black box using the places $P_{h1}$ and $P_{h2}$ as the terminal units as seen from the host.

The display procedures when the system simulation in this example is executed are shown in Figs. 15(a) to (d) and Fig. 16 (a) to (c). Here, the display procedrues shown are those which are executed by the uppermost-rank function.

Fig. 15 shows the operation of the whole system macroscopically. The cash dispenser executes "cash card reception" as a result of the first transition, and the host computer waits for the execution of "balance certification" as shown in Fig. 15(a). As a result of the second transition, as shown in Fig. 15(b), the cash dispenser executes "reception of cash payment", and the host computer is awaits for "balance certification". As a result of the third transition (as shown in Fig. 15(c)), the cash dispenser requests "balance certification" of the host computer and waits for it while the host computer executes "balance certification". As a result of the fourth transition, as shown in Fig. 15(d), the cash dispenser executes "cash payment", and the host computer executes "balance renewal". Upon the third transition, "payment data" are removed from the cash dispenser to the host computer. Upon the fourth transition, "cash payment amount" is delivered from the host computer to the cash dispenser.

Figs. 16(a) to (c) show the data structure transformation procedures by the specific token removal. Of the displayed examples, Fig. 16(c) shows the first transition display.

In Fig. 16: the solid circle indicates the initial position of the token; the blank circle indicates the first position; the solid triangle indicates the second position; the blank triangle indicates the third position; and the solid square indicates the fourth position.

Figs. 17(a) and (b) show the changes of the token presence flags of the function simulation shown in Fig. 12. Fig. 17(a) shows the cash dispenser token presence flag and corresponds to Fig. 16(a). Fig. 17(b) shows the token presence flag in the host computer and corresponds to Fig. 16-(b).

With the present system, function simulation of a distributed processing system can be executed properly even in a large, complex system.

Although a cash dispenser has been described hereinbefore, the present invention can be similarly applied to other systems.

## Claims

**1.** A method of operating a data processing system for simulating the functions of a distributed system constructed of independently and asynchronously operative processes transferring information to or from each other, comprising the steps of:

preparing a Petri net model for each process;

storing a whole structure table (31) associating to each pair of interacting processes one or more functions carried out by one process to serve the other one, and the input and output data of said function transferred between the processes of said pair;

storing a system structure table (32) corresponding to the Petri net model for each of said processes, including place names (5f), names (5g) of data structures representing the information associated to each place, transition names (5b), names (5c) of functions associated to said transitions and carried out to process said information when a token passes a transition, and indicators (5ℓ) representing the arcs and indicating the relationship between places and transitions;

defining a data structure of the input and output data of each function and storing said data structure in a data structure table (33);

initiating the simulation by presetting said places with tokens; and

simulating said distributed system by removing and placing said tokens according to Petri net rules with the following substeps:

preparing the data associated with the places at the input and output of a transition, and

executing the function associated with this transition,

wherein reference to the input and output data of the functions is made by using the data structure names stored in the whole structure table (31) and in the system structure table (32) as keys for the data structure table (33).

**2.** The method of claim 1, wherein a particular transition ($T_{CD5}$, Fig. 3) is represented by a sub-Petri net (Fig. 2) defined in a lower level system structure table labelled by the name (5a) of the function associated with the particular transition ($T_{CD5}$), and wherein the step of executing the associated function includes:

searching the lower level system structure table by means of the function name,

moving the tokens at the input places of the particular transition ($T_{CD5}$) to respective places in the lower level system structure table according to coinciding data structure names,

processing said lower level system structure table according to Petri net rules, and

moving the tokens at the output places of the particular transition ($T_{CD5}$) to respective places in the upper level system structure table according to coinciding data structure names.

**3.** A function simulating system for simulating a distributed system according to the method of claim 1 or 2, comprising:

a whole structure table memory means (31),

containing a whole structure table (31) associating to each pair of interacting processes one or more functions carried out by one process to serve the other one, and the input and output data of said function transferred between the processes of said pair;

a target system structure table memory means (32),

containing a system structure table (32) corresponding to the Petri net model for each of said processes, including place names (5f), names (5g) of data structures representing the information associated to each place, transition names (5b), names (5c) of functions associated to said transitions and carried out to process said information when a token passes a transition, and indicators (5ℓ) representing the arcs and indicating the relationship between places and transitions;

a data structure table memory-means (33),

containing a data structure of the input and output data of each function;

a simulation system means (30)

comprising means for initiating the simulation by presetting said places with tokens; and

simulating said distributed system by removing and placing said tokens according to Petri net rules with the following substeps:

preparing the data associated with the places at the input and output of a transition, and

executing the function associated with this transition,

wherein reference to the input and output data of the functions is made by using the data structure names stored in the whole structure table (31) and in the system structure table (32) as keys for the data structure table (33), and

display means (36) for displaying the simulation result.

## Revendications

**1.** Procédé d'exploitation d'un système de traitement de données pour simuler les fonctions d'un système réparti constitué de processus agissant indépendamment et de façon asynchrone transférant des informations entre eux, comportant les étapes consistant à :

préparer un modèle de réseau de Pétri pour chaque processus ;

mémoriser une table (31) de la totalité de la structure associant à chaque paire de processus interactifs une ou plusieurs fonctions effectuées par un processus pour servir l'autre, et les données d'entrée et de sortie desdites fonctions transférées entre les processus de ladite paire ;

mémoriser une table (32) de la structure du système correspondant au modèle de réseau de Pétri pour chacun desdits processus, comprenant des indicatifs d'emplacement (5f), des indicatifs (5g) de structures de données représentant l'information associée à chaque emplacement, des indicatifs de transition (5b), des indicatifs (5c) de fonctions associées auxdites transitions et effectuées pour traiter ladite information lorsqu'un jeton traverse une transition, et des indicateurs (5ℓ) représentant les arcs et indiquant la relation entre des emplacements et des transitions ;

définir une structure de données des données d'entrée et de sortie de chaque fonction et mémoriser ladite structure de données dans une table de structure de données (33) ;

déclencher la simulation en prédéterminant lesdits emplacements avec des jetons ; et

simuler ledit système réparti en retirant et en plaçant lesdits jetons selon les règles du réseau de Pétri avec les sous-étapes suivantes :

préparer les données associées aux emplacements à l'entrée et à la sortie d'une transition, et

exécuter la fonction associée à cette transition, dans lequel une référence aux données d'entrée et de sortie des fonctions est faite en utilisant les indicatifs de structure de données mémorisés dans la table (31) de la totalité de la structure et dans la table de structure de système (32) en tant que clés pour la table de structure de données (33).

2. Procédé selon la revendication 1, dans lequel une transition particulière ($T_{CD5}$, Figure 3) est représentée par un sous-réseau de Pétri (Figure 2) défini dans une table de structure de système de niveau inférieur identifiée par l'indicatif (5a) de la fonction associée à la transition particulière ($T_{CD5}$), et dans lequel l'étape d'exécution de la fonction associée comprend :

la recherche de la table de structure de système de niveau inférieur à l'aide de l'indicatif de fonction ;

le déplacement des jetons aux emplacements d'entrée de la transition particulière ($T_{CD5}$) vers des emplacements respectifs dans la table de structure de système de niveau inférieur selon des indicatifs de structure de données coïncidants,

le traitement de ladite table de structure de système de niveau inférieur selon les règles du réseau de Pétri, et

le déplacement des jetons aux emplacements de sortie de la transition particulière ($T_{CD5}$) vers des emplacements respectifs dans la table de structure de système de niveau supérieur conformément aux indicatifs de structure de données coïncidants.

3. Système de simulation de fonction pour simuler un système réparti selon le procédé de la revendication 1 ou 2, comportant :

des moyens formant mémoire de table de la totalité de la structure (31), contenant une table de la totalité de la structure (31) associant à chaque paire de processus interactifs une ou plusieurs fonctions exécutées par un processus pour servir l'autre, et les données d'entrée et de sortie desdites fonctions transférées entre les processus de ladite paire ;

des moyens formant mémoire de table de structure de système cible (32), contenant une table de structure de système (32) correspondant au modèle de réseau de Pétri pour chacun desdits processus, comprenant des indicatifs d'emplacement (5f), des indicatifs (5g) de structures de données représentant l'information associée à chaque emplacement, des indicatifs de transition (5d), des indicatifs (5c) de fonctions associées auxdites transitions et exécutées pour traiter ladite information lorsqu'un jeton traverse une transition, et des indicateurs (5ℓ) représentant les arcs et indiquant la relation entre les emplacements et les transitions ;

des moyens formant mémoire de table de structure de données (33), contenant une structure de données des données d'entrée et de sortie de chaque fonction ;

des moyens formant système de simulation (30) comprenant des moyens pour déclencher la simulation en prédéterminant lesdits emplacements avec des jetons ; et

simuler ledit système réparti en retirant et en plaçant lesdits jetons selon les règles du réseau de Pétri avec les sous-étapes suivantes :

préparer les données associées aux emplacements à l'entrée et à la sortie d'une transition, et

exécuter la fonction associée à cette transition,

dans lequel une référence aux données d'entrée et de sortie des fonctions est faite en utilisant les indicatifs de structure de données mémorisés dans la table de la totalité de la structure (30) et dans la table de structure de système (32) en tant que clés pour la table de structure de données (33), et

des moyens d'affichage (36) pour afficher le résultat de la simulation.

## Patentansprüche

1. Verfahren zum Betrieb eines Datenverarbeitungssystems, um die Funktionen eines verteilten Systems zu simulieren, das aus unabhängig voneinander und asynchron arbeitenden Prozessen aufgebaut ist, die Information zwischeneinander übertragen, mit folgenden Schritten:

Aufstellen eines Petrinetz-Modells für jeden Prozeß,

Speichern einer Gesamtstruktur-Tabelle (31), die jedem Paar miteinander wechselwirkender Prozesse eine oder mehrere Funktionen , die von einem der Prozesse ausgeführt werden, um den anderen zu bedienen, und die zwischen den Prozessen des Paares übertragenen Ein- und Ausgangsdaten der genannten Funktionen zuordnet,

Speichern einer Systemstruktur-Tabelle (32) entsprechend dem Petrinetz-Modell jedes der Prozesse mit Namen (5f) von "Plätzen", Namen (5g) von Datenstrukturen, die die jedem "Platz" zugeordnete Information darstellen, Namen (5b) von "Übergängen", Namen (5c) von Funktionen, die den "Übergängen" zugeordnet sind und zur Informationsverarbeitung ausgeführt werden, wenn ein "Token" einen "Übergang" passiert, und Indikatoren (51), die die "Pfeile" darstellen und die Beziehung zwischen "Plätzen" und "Übergängen" angeben,

Festlegen einer Datenstruktur der Ein- und Ausgangsdaten jeder Funktion und Speichern dieser Datenstruktur in einer Datenstruktur-Tabelle (33),

Initialisieren der Simulation durch Vorbesetzen der "Plätze" mit "Token", und

Simulieren des verteilten Systems durch Wegbewegen und Setzen der "Token" entsprechend den Regeln eines Petrinetzes mit folgenden Unterschritten:

Vorbereiten der Daten, die den "Plätzen" am Eingang und Ausgang eines "Übergangs" zugeordnet sind, und

Ausführen der diesem "Übergang" zugeordneten Funktion,

wobei der Bezug zu den Ein- und Ausgangsdaten der Funktionen unter Verwendung der in der Gesamtstruktur-Tabelle (31) und in der Systemstruktur-Tabelle (32) gespeicherten Datenstruktur-Namen als Schlüssel für die Datenstruktur-Tabelle (33) erfolgt.

**2.** Verfahren nach Anspruch 1, wobei ein bestimmter "Übergang" ($T_{CD5}$, Figur 3) durch ein Unter-Petrinetz (Figur 2) dargestellt wird, das in einer Systemstruktur-Tabelle niedrigerer Ordnung definiert ist, die durch den Namen (5a) der dem bestimmten "Übergang" ($T_{CD5}$) zugeordneten Funktion markiert ist, und wobei der Ausführungsschritt der zugeordneten Funktion folgende Schritte beinhaltet:

Suchen der Systemstruktur-Tabelle niedrigerer Ordnung mittels des Funktionsnamens,

Bewegen der "Token" an den Eingangs-"Plätzen" des bestimmten Übergangs ($T_{CD5}$) zu entsprechenden "Plätzen" in der Systemstruktur-Tabelle niedrigerer Ordnung entsprechend übereinstimmender Datenstruktur-Namen,

Bearbeiten der Systemstruktur-Tabelle niedrigerer Ordnung nach Petrinetz-Regeln, und

Bewegen der "Token" an den Ausgangs-"Plätzen" des bestimmten "Übergangs" ($T_{CD5}$) zu entsprechenden "Plätzen" in der Systemstruktur-Tabelle höherer Ordnung entsprechend übereinstimmender Datenstruktur-Namen.

**3.** Funktionssimulations-System zur Simulation eines verteilten Systems nach dem Verfahren der Ansprüche 1 oder 2, umfassend:

eine Gesamtstruktur-Tabellenspeichereinrichtung (31), die eine Gesamtstruktur-Tabelle (31) beinhaltet, die jedem Paar wechselwirkender Prozesse eine oder mehrere von einem Prozeß zur Bedienung des anderen ausgeführte Funktionen und die zwischen den Prozessen des Paares übertragenen Eingangs- und Ausgangsdaten der Funktionen zuordnet,

eine Zielsystemstruktur-Tabellenspeichereinrichtung (32), die eine Systemstruktur-Tabelle (32) beinhaltet, die für jeden der genannten Prozesse einem Petrinetz-Modell entspricht und Namen (5f) von "Plätzen", Namen (5g) von Datenstrukturen, die die jedem Platz zugeordnete Information darstellen, Namen (5b) von "Übergängen", Namen (5c) von Funktionen, die den "Übergängen" zugeordnet sind und zur Informationsverarbeitung ausgeführt werden, wenn ein "Token" einen "Übergang" passiert, und Indikatoren (51), die die "Pfeile" darstellen und die Beziehung zwischen "Plätzen" und "Übergängen" angeben, beinhaltet,

eine Datenstruktur-Tabellenspeichereinrichtung (33), die eine Datenstruktur der Eingangs- und Ausgangsdaten jeder Funktion beinhaltet,

eine Simulations-Systemeinrichtung (30) mit Einrichtungen

zur Initialisierung der Simulation durch Vorbesetzen der genannten "Plätze" mit "Token", und

zur Simulation des verteilten Systems durch Wegbewegen und Setzen der genannten "Token" nach Petrinetz-Regeln mit folgenden Unterschritten:

Vorbereiten der den "Plätzen" am Eingang und Ausgang eines "Übergangs" zugeordneten Daten, und

Ausführen der diesem "Übergang" zugeordneten Funktion,

wobei der Bezug zu den Eingangs- und Ausgangsdaten der Funktionen durch die Verwendung der in der Gesamtstruktur-Tabelle (31) und in der Systemstruktur-Tabelle (32) gespeicherten Datenstruktur-Namen als Schlüssel für die Datenstruktur-Tabelle (33) hergestellt wird, und

Anzeigeeinrichtungen (36) zur Anzeige des Simulationsergebnisses.

FIG. 1

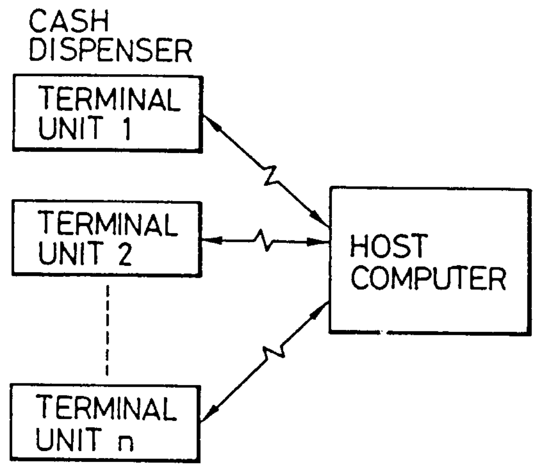
CASH DISPENSER
TERMINAL UNIT 1
TERMINAL UNIT 2
TERMINAL UNIT n
HOST COMPUTER

FIG. 2

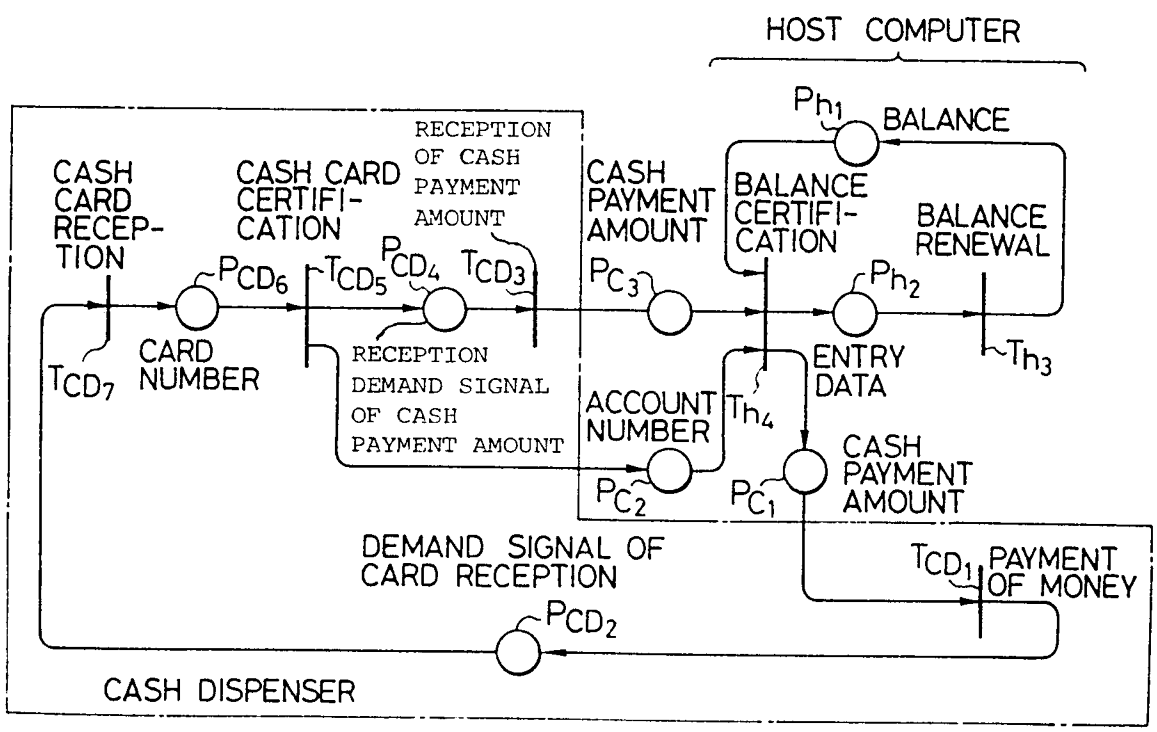
HOST COMPUTER
Ph1
BALANCE
CASH CARD RECEPTION
CASH CARD CERTIFICATION
RECEPTION OF CASH PAYMENT AMOUNT
CASH PAYMENT AMOUNT
BALANCE CERTIFICATION
BALANCE RENEWAL
PCD6
TCD5
PCD4
TCD3
PC3
Ph2
TCD7
CARD NUMBER
RECEPTION DEMAND SIGNAL OF CASH PAYMENT AMOUNT
ACCOUNT NUMBER
Th4
ENTRY DATA
Th3
CASH PAYMENT AMOUNT
PC2
PC1
DEMAND SIGNAL OF CARD RECEPTION
TCD1
PAYMENT OF MONEY
PCD2
CASH DISPENSER

FIG. 3

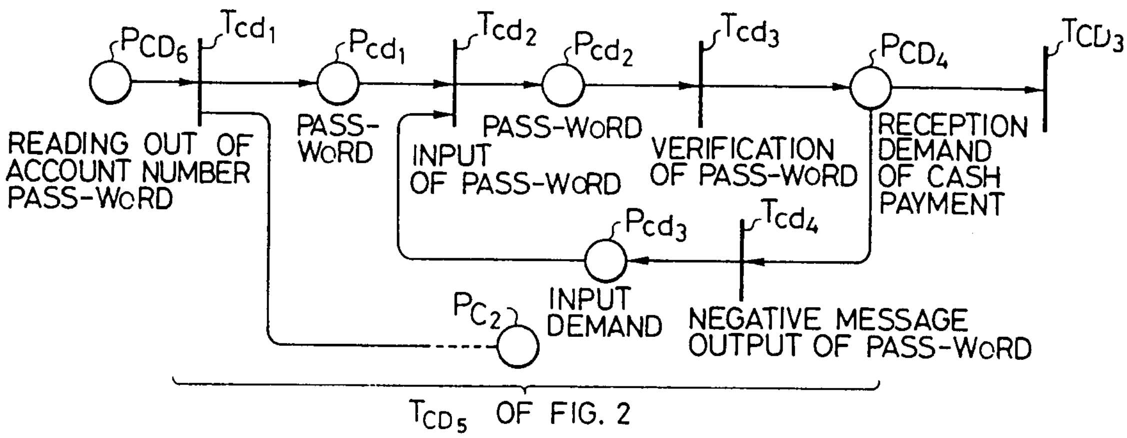
$P_{CD_6}$
$T_{cd_1}$
$P_{cd_1}$
$T_{cd_2}$
$P_{cd_2}$
$T_{cd_3}$
$P_{CD_4}$
$T_{CD_3}$
READING OUT OF ACCOUNT NUMBER PASS-WORD
PASS-WORD
INPUT OF PASS-WORD
PASS-WORD
VERIFICATION OF PASS-WORD
RECEPTION DEMAND OF CASH PAYMENT
$P_{cd_3}$
$T_{cd_4}$
$P_{C_2}$
INPUT DEMAND
NEGATIVE MESSAGE OUTPUT OF PASS-WORD
$T_{CD_5}$ OF FIG. 2

FIG. 4

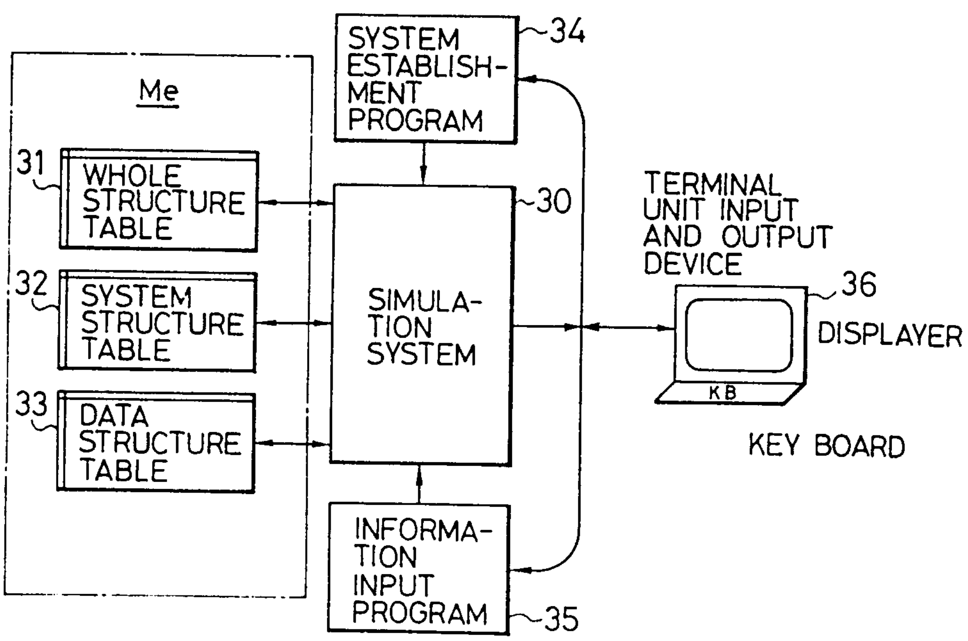
SYSTEM ESTABLISH-MENT PROGRAM
34
Me
31
WHOLE STRUCTURE TABLE
32
SYSTEM STRUCTURE TABLE
33
DATA STRUCTURE TABLE
SIMULA-TION SYSTEM
30
INFORMA-TION INPUT PROGRAM
35
TERMINAL UNIT INPUT AND OUTPUT DEVICE
36
DISPLAYER
KB
KEY BOARD

FIG. 5

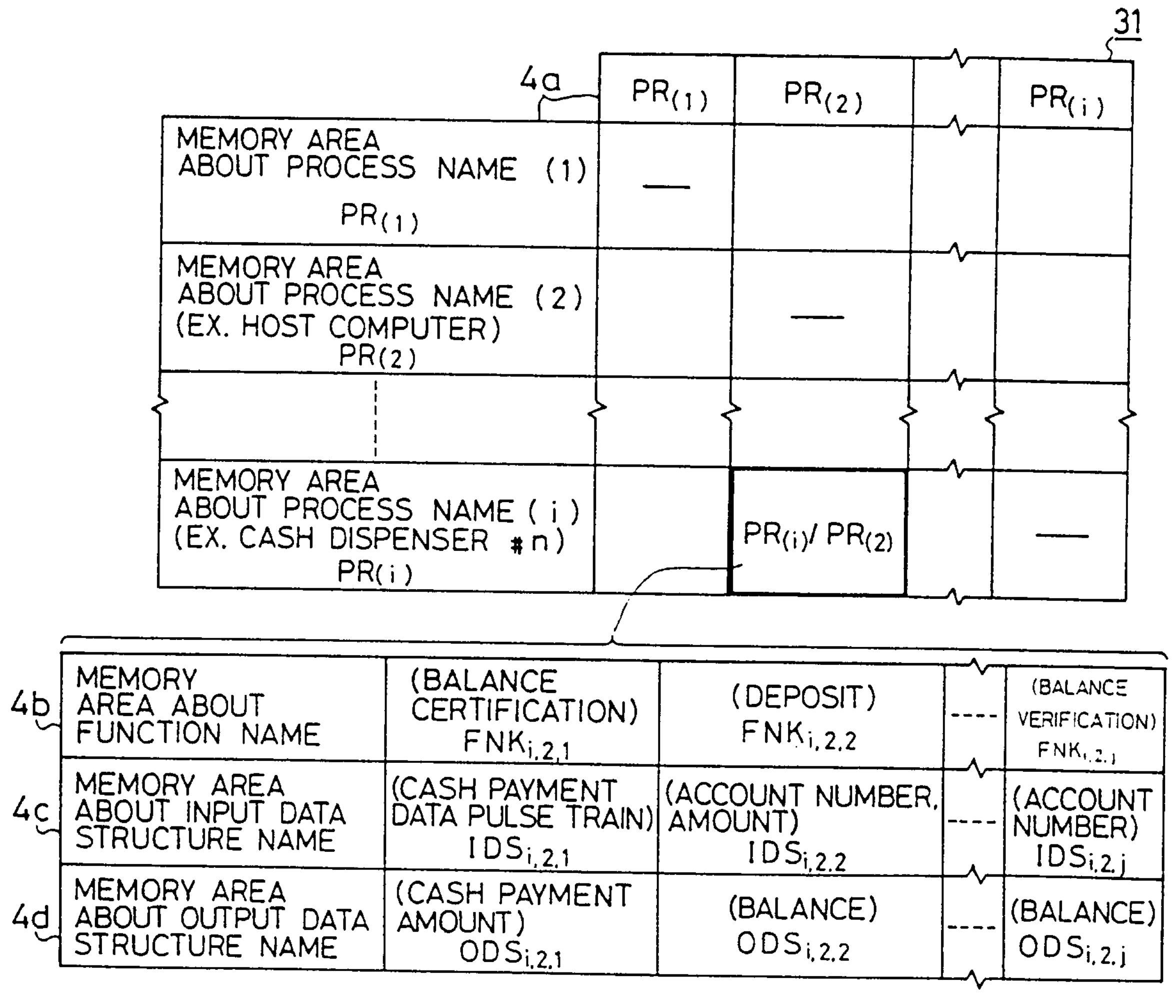
31
4a
PR(1)
PR(2)
PR(i)
MEMORY AREA ABOUT PROCESS NAME (1) PR(1)
MEMORY AREA ABOUT PROCESS NAME (2) (EX. HOST COMPUTER) PR(2)
MEMORY AREA ABOUT PROCESS NAME (i) (EX. CASH DISPENSER #n) PR(i)
PR(i)/PR(2)
4b
MEMORY AREA ABOUT FUNCTION NAME
(BALANCE CERTIFICATION) FNKi,2,1
(DEPOSIT) FNKi,2,2
(BALANCE VERIFICATION) FNKi,2,j
4c
MEMORY AREA ABOUT INPUT DATA STRUCTURE NAME
(CASH PAYMENT DATA PULSE TRAIN) IDSi,2,1
(ACCOUNT NUMBER, AMOUNT) IDSi,2,2
(ACCOUNT NUMBER) IDSi,2,j
4d
MEMORY AREA ABOUT OUTPUT DATA STRUCTURE NAME
(CASH PAYMENT AMOUNT) ODSi,2,1
(BALANCE) ODSi,2,2
(BALANCE) ODSi,2,j

FIG. 6

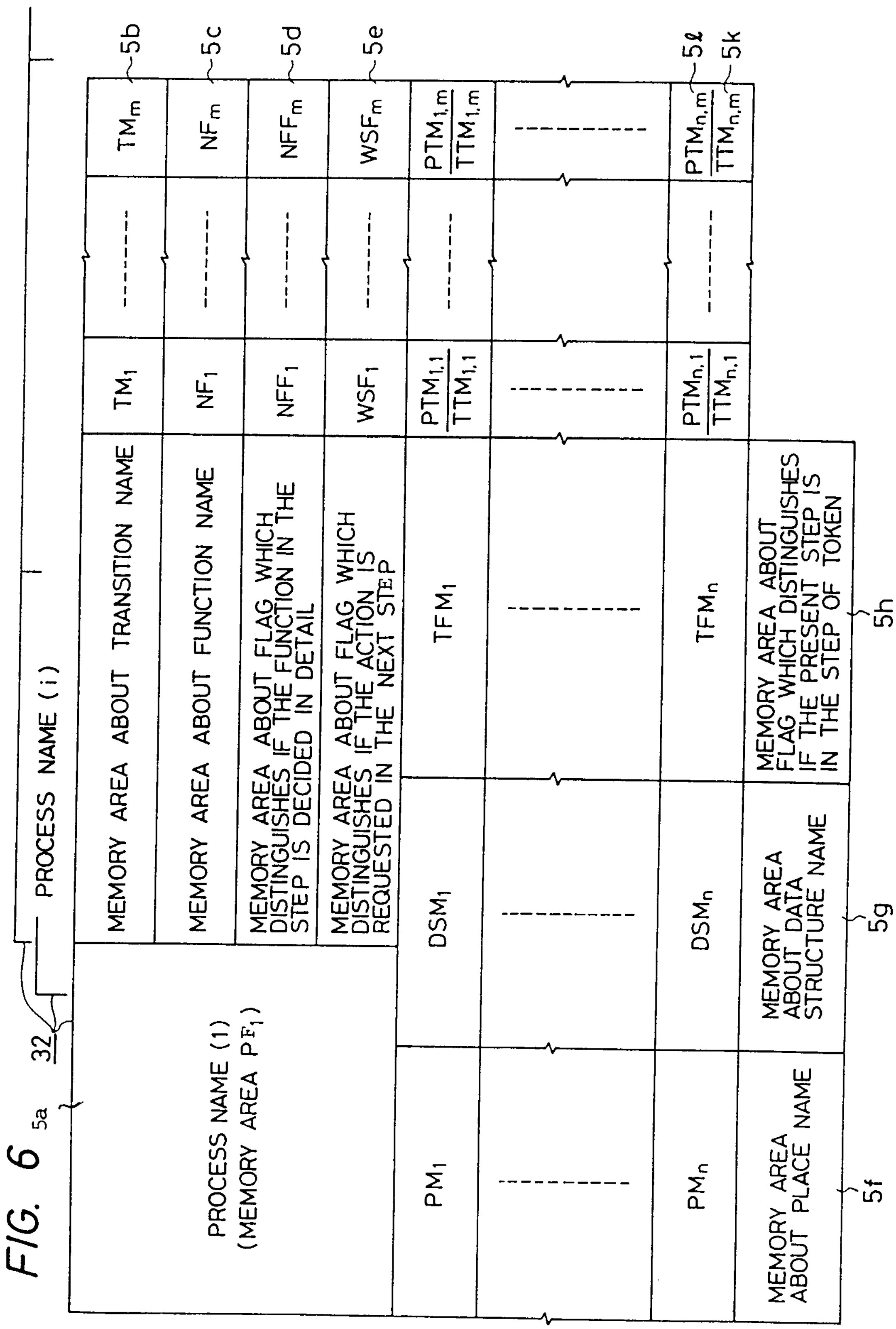
32
5a
PROCESS NAME (i)
PROCESS NAME (1) (MEMORY AREA PF1)
MEMORY AREA ABOUT TRANSITION NAME
MEMORY AREA ABOUT FUNCTION NAME
MEMORY AREA ABOUT FLAG WHICH DISTINGUISHES IF THE FUNCTION IN THE STEP IS DECIDED IN DETAIL
MEMORY AREA ABOUT FLAG WHICH DISTINGUISHES IF THE ACTION IS REQUESTED IN THE NEXT STEP
TM1
TMm
NF1
NFm
NFF1
NFFm
WSF1
WSFm
5b
5c
5d
5e
PM1
DSM1
TFM1
PTM1,1 / TTM1,1
PTM1,m / TTM1,m
PMn
DSMn
TFMn
PTMn,1 / TTMn,1
PTMn,m / TTMn,m
5ℓ
5k
MEMORY AREA ABOUT PLACE NAME
MEMORY AREA ABOUT DATA STRUCTURE NAME
MEMORY AREA ABOUT FLAG WHICH DISTINGUISHES IF THE PRESENT STEP IS IN THE STEP OF TOKEN
5f
5g
5h

FIG. 7

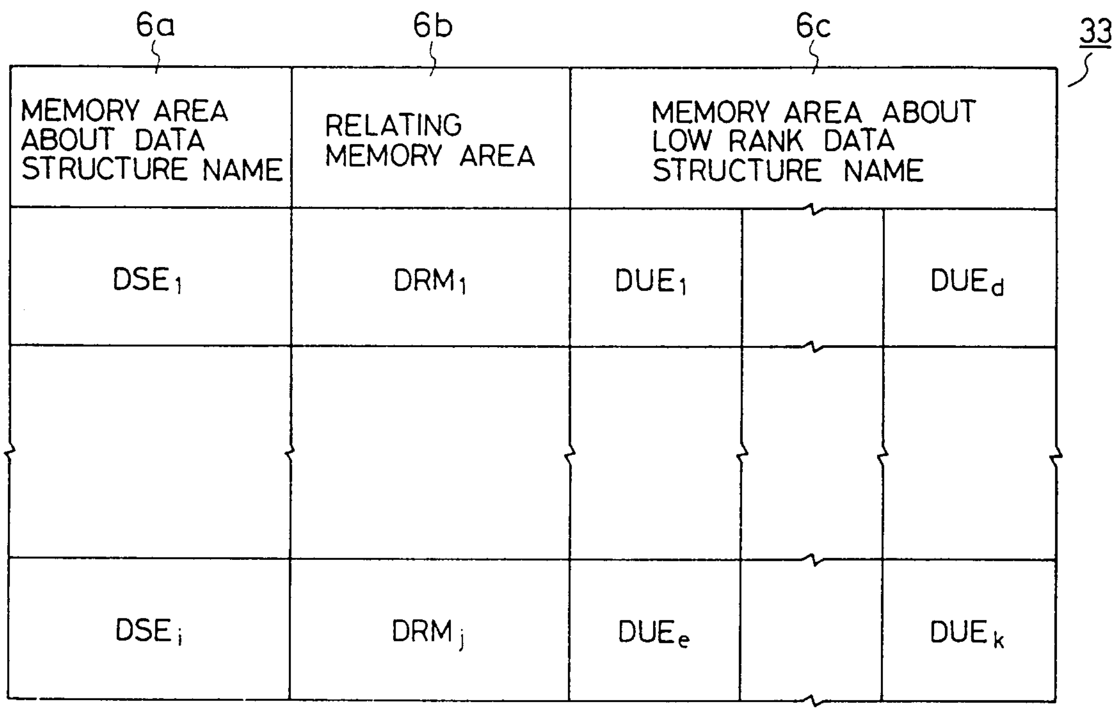
6a
6b
6c
33
MEMORY AREA ABOUT DATA STRUCTURE NAME
RELATING MEMORY AREA
MEMORY AREA ABOUT LOW RANK DATA STRUCTURE NAME
DSE$_1$
DRM$_1$
DUE$_1$
DUE$_d$
DSE$_i$
DRM$_j$
DUE$_e$
DUE$_k$

FIG. 8

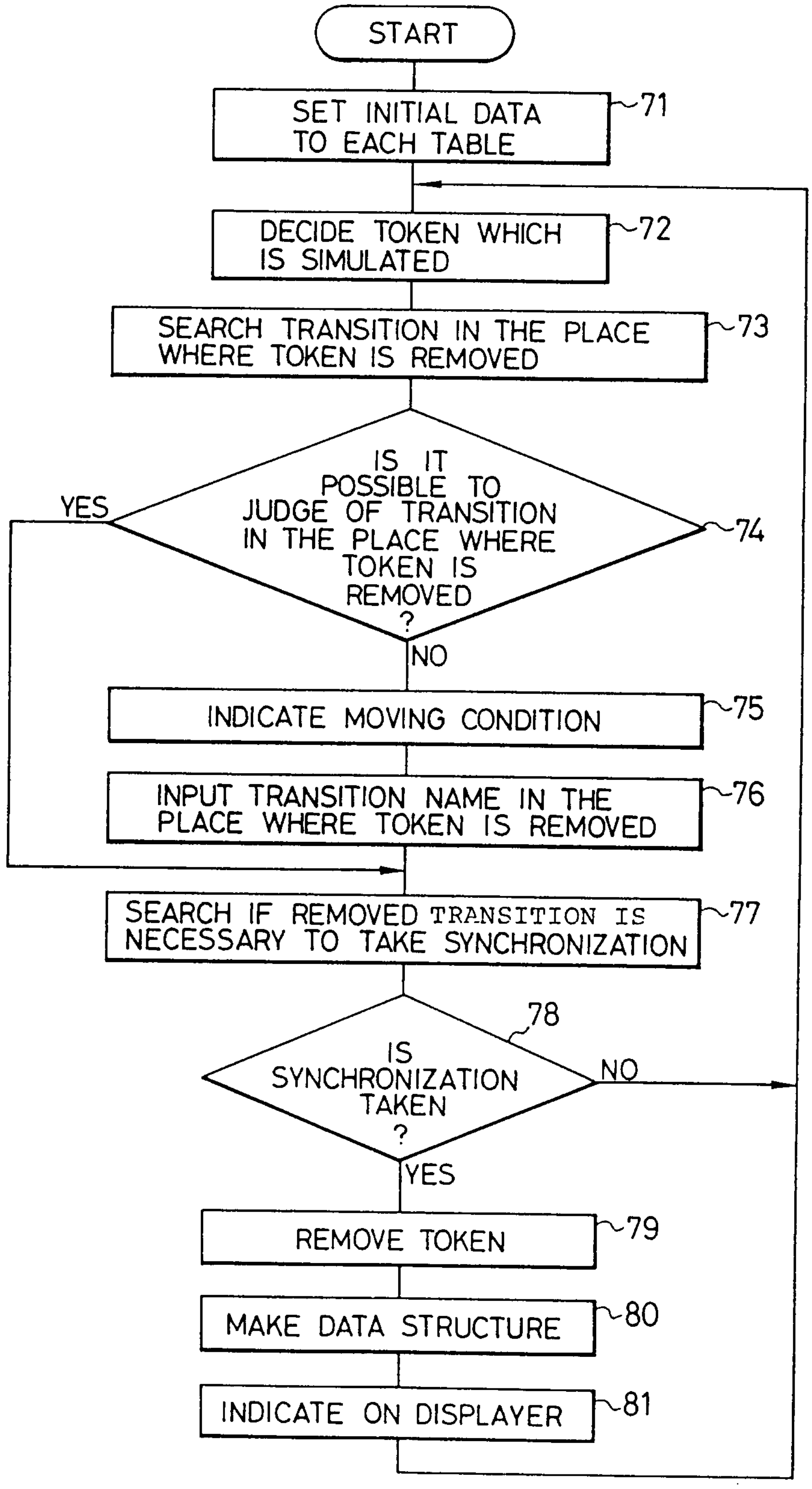
START
SET INITIAL DATA TO EACH TABLE
71
DECIDE TOKEN WHICH IS SIMULATED
72
SEARCH TRANSITION IN THE PLACE WHERE TOKEN IS REMOVED
73
IS IT POSSIBLE TO JUDGE OF TRANSITION IN THE PLACE WHERE TOKEN IS REMOVED ?
74
YES
NO
INDICATE MOVING CONDITION
75
INPUT TRANSITION NAME IN THE PLACE WHERE TOKEN IS REMOVED
76
SEARCH IF REMOVED TRANSITION IS NECESSARY TO TAKE SYNCHRONIZATION
77
IS SYNCHRONIZATION TAKEN ?
78
NO
YES
REMOVE TOKEN
79
MAKE DATA STRUCTURE
80
INDICATE ON DISPLAYER
81

FIG. 9(a)

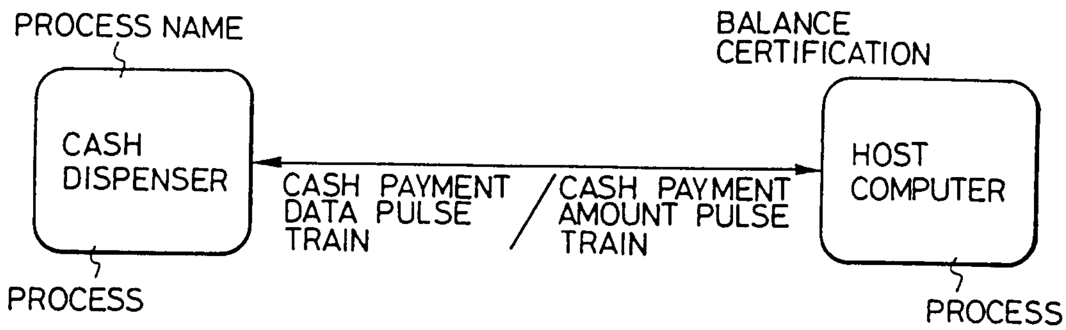


FIG. 9(b)

FIG. 9(c)

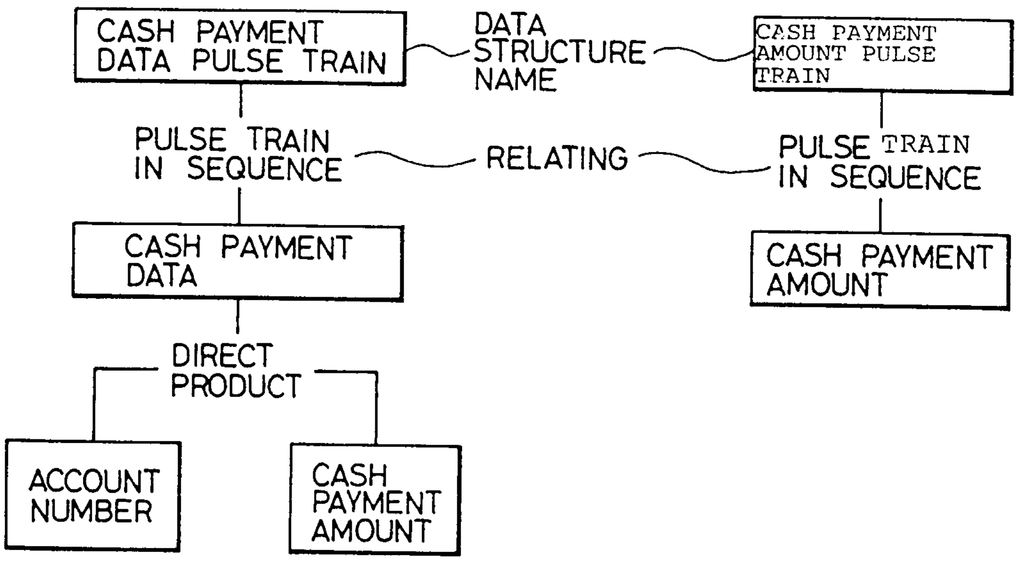


FIG. 9(d)

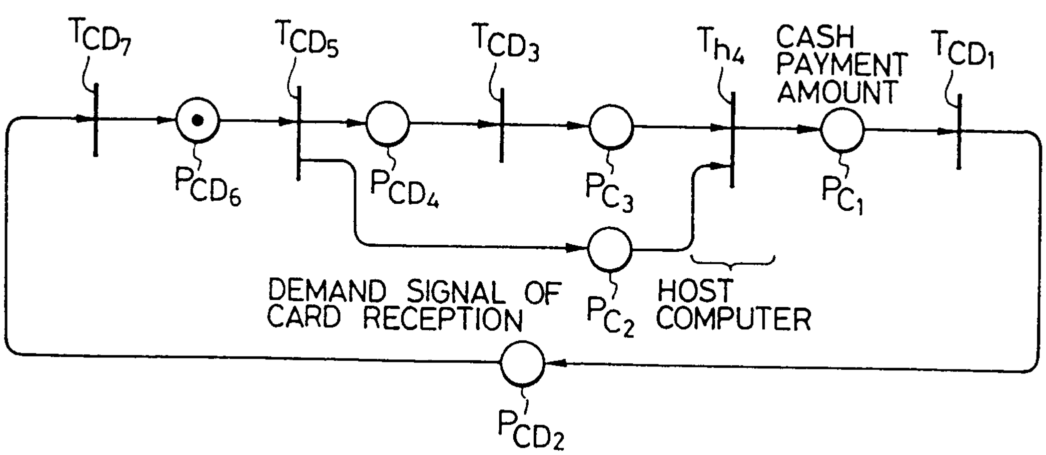

FIG. 9(e)

FIG. 9(f)

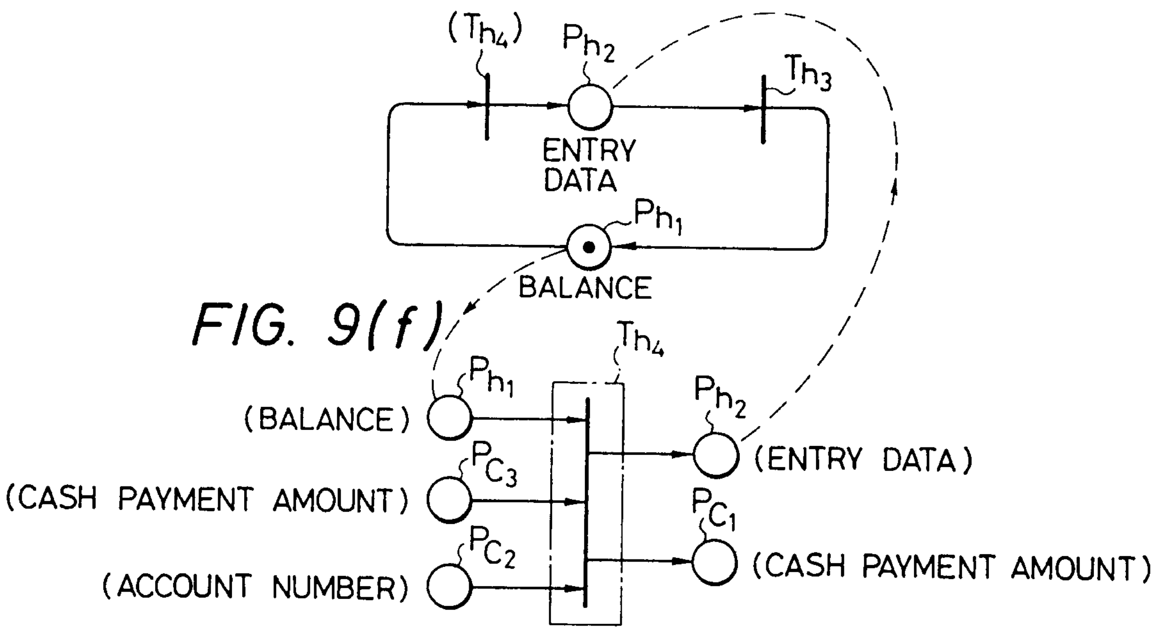


FIG. 9(g)

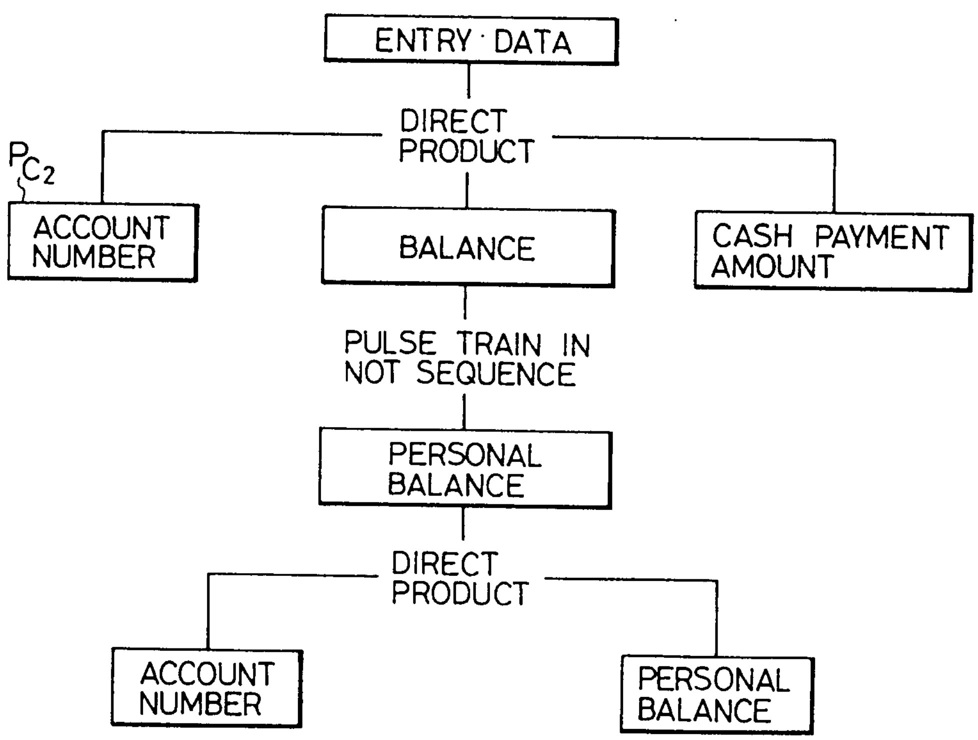

FIG. 10

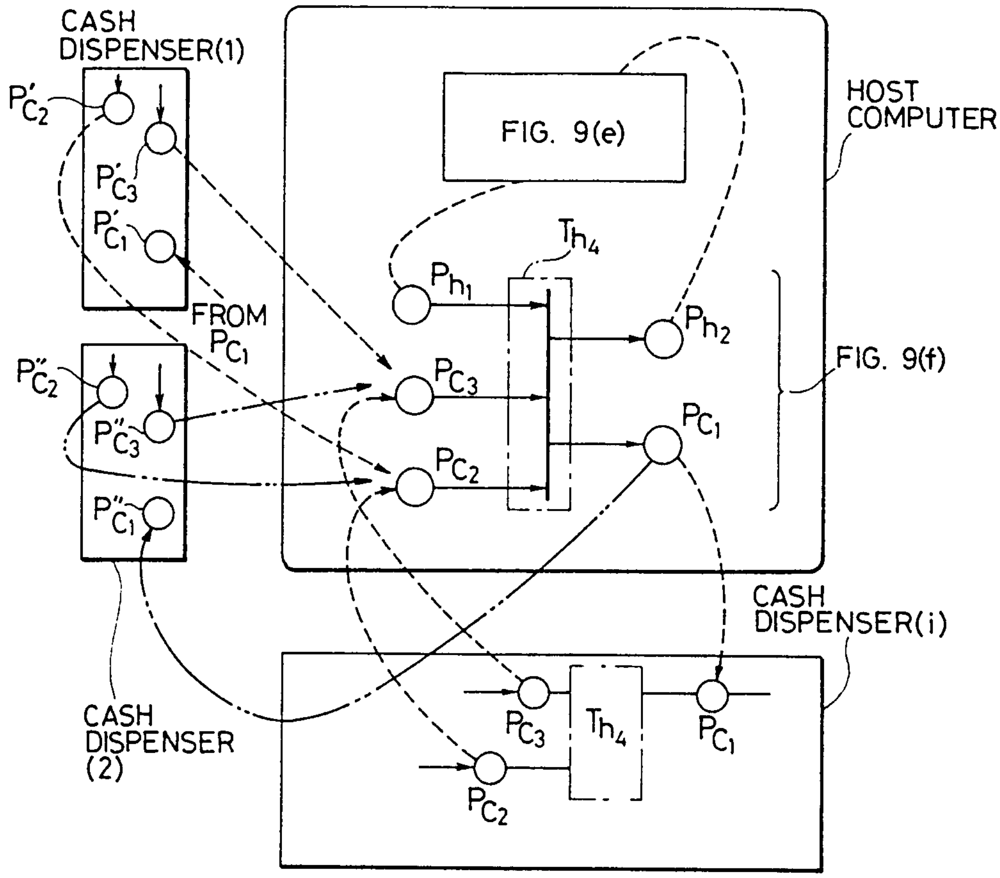


FIG. 11

| | CASH DISPENSER | HOST COMPUTER |
|---|---|---|
| CASH DISPENSER | — | BALANCE CERTIFICATION<br>CASH PAYMENT DATA PULSE TRAIN<br>CASH PAYMENT AMOUNT PULSE TRAIN |
| HOST COMPUTER | — | — |

(31)

## FIG. 12

5a (32)

| | | | $T_{CD_7}$ | $T_{CD_5}$ | $T_{CD_3}$ | $T_{CD_4}$ | $T_{CD_1}$ |
|---|---|---|---|---|---|---|---|
| CASH DISPENSER | | 5b | | | | | |
| | | 5c | CASH CARD RECEPTION | CASH CARD CERTIFICATION | RECEPTION OF CASH PAYMENT AMOUNT | BALANCE CERTIFICATION BY HOST COMPUTER | CASH PAYMENT |
| | | 5d | FUNCTION IS NOT DECIDED IN DETAIL | FUNCTION IS DECIDED AS SHOWN IN FIG. 3 | FUNCTION IS NOT DECIDED IN DETAIL | FUNCTION IS NOT DECIDED IN DETAIL | FUNCTION IS NOT DECIDED IN DETAIL |
| | | 5e | 0 | 0 | 0 | 0 | 0 |
| $P_{CD_6}$ | CARD NUMBER | 0 | -1 | 1 | 0 | 0 | 0 |
| | | | – | – | – | – | – |
| $P_{CD_4}$ | RECEPTION DEMAND SIGNAL OF CASH PAYMENT AMOUNT | 0 | 0 | -1 | 1 | 0 | 0 |
| | | | – | – | – | – | – |
| $P_{C_3}$ | CASH PAYMENT AMOUNT | 0 | 0 | 0 | -1 | 1 | 0 |
| | | | – | – | – | – | – |
| $P_{C_2}$ | ACCOUNT NUMBER | 0 | 0 | -1 | 0 | 1 | 0 |
| | | | – | – | – | – | – |
| $P_{C_1}$ | CASH PAYMENT AMOUNT | 0 | 0 | 0 | 0 | -1 | 1 |
| | | | – | – | – | – | – |
| $P_{CD_2}$ | DEMAND SIGNAL OF CARD RECEPTION | 0 | 1 | 0 | 0 | 0 | -1 |
| | | | – | – | – | – | – |

(5f) (5g) 5h 5k 5ℓ

FIG. 13

| | | | | |
|---|---|---|---|---|
| CASH PAYMENT DATA PULSE TRAIN | PULSE TRAIN IN SEQUENCE | CASH PAYMENT DATA | — | — |
| CASE PAYMENT DATA | DIRECT PRODUCT | ACCOUNT NUMBER | CASH PAYMENT AMOUNT | — |
| ACCOUNT NUMBER | — | — | — | — |
| CASH PAYMENT AMOUNT | — | — | — | — |
| CASH PAYMENT AMOUNT PULSE TRAIN | PULSE TRAIN IN SEQUENCE | CASH PAYMENT AMOUNT | — | — |
| CASH PAYMENT AMOUNT | — | — | — | — |
| CARD NUMBER | — | — | — | — |
| RECEPTION DEMAND SIGNAL OF CASH PAYMENT | — | — | — | — |
| CARD RECEPTION DEMAND | — | — | — | — |
| INPUT DEMAND | — | — | — | — |
| ENTRY DATA | DIRECT PRODUCT | ACCOUNT NUMBER | BALANCE | CASH PAYMENT AMOUNT |
| BALANCE | PULSE TRAIN IN NOT SEQUENCE | PERSONAL BALANCE | — | — |
| PERSONAL BALANCE | DIRECT PRODUCT | ACCOUNT NUMBER | PERSONAL BALANCE | — |
| PERSONAL BALANCE | — | — | — | — |

FIG. 14

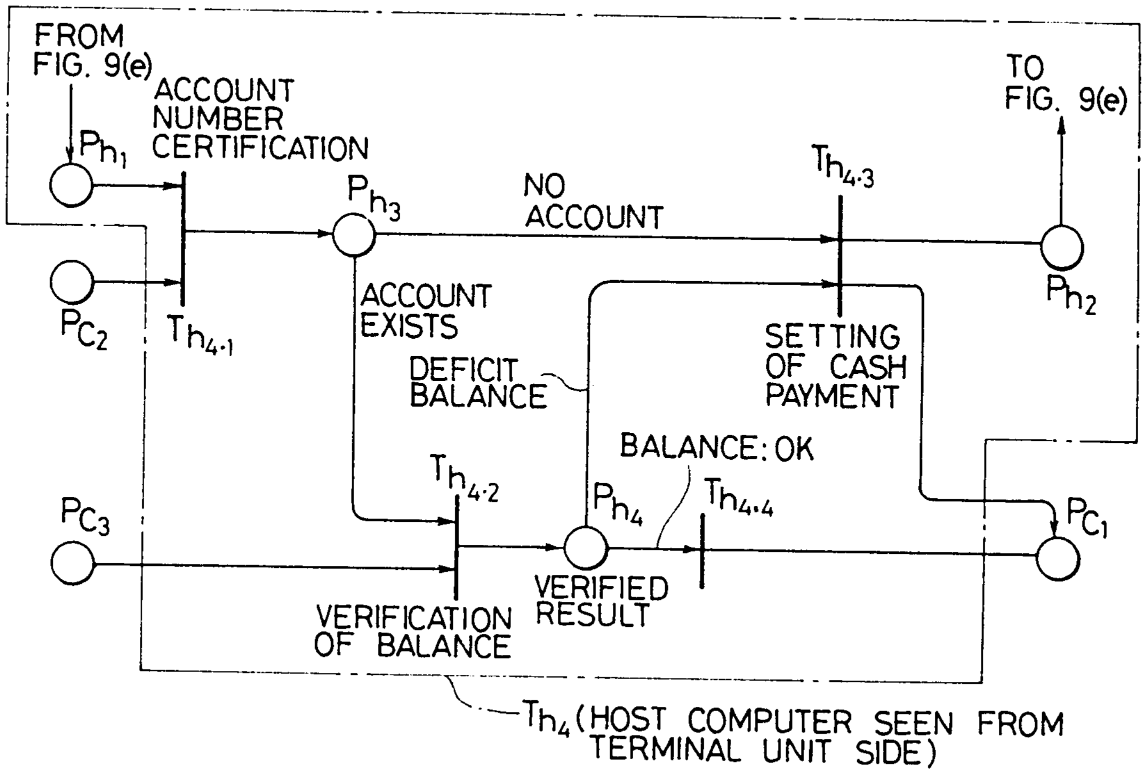
FROM
FIG. 9(e)
ACCOUNT
NUMBER
CERTIFICATION
Ph1
Ph3
NO
ACCOUNT
Th4·3
TO
FIG. 9(e)
Ph2
PC2
Th4·1
ACCOUNT
EXISTS
DEFICIT
BALANCE
SETTING
OF CASH
PAYMENT
BALANCE: OK
Th4·2
Ph4
Th4·4
PC3
PC1
VERIFIED
RESULT
VERIFICATION
OF BALANCE
Th4 (HOST COMPUTER SEEN FROM
TERMINAL UNIT SIDE)

FIG. 15(a)

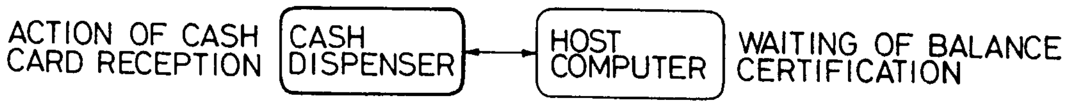


FIG. 15(b)

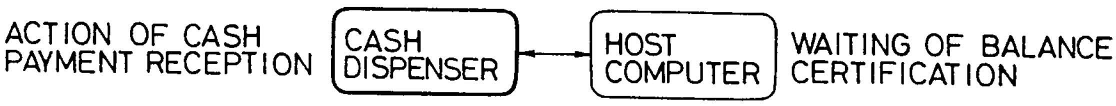


FIG. 15(c)

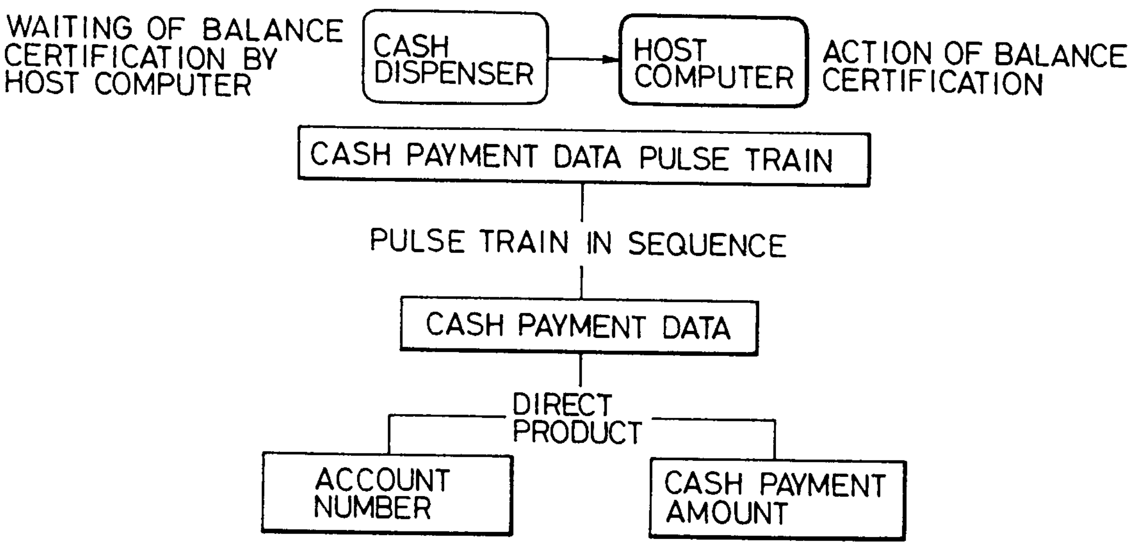


FIG. 15(d)

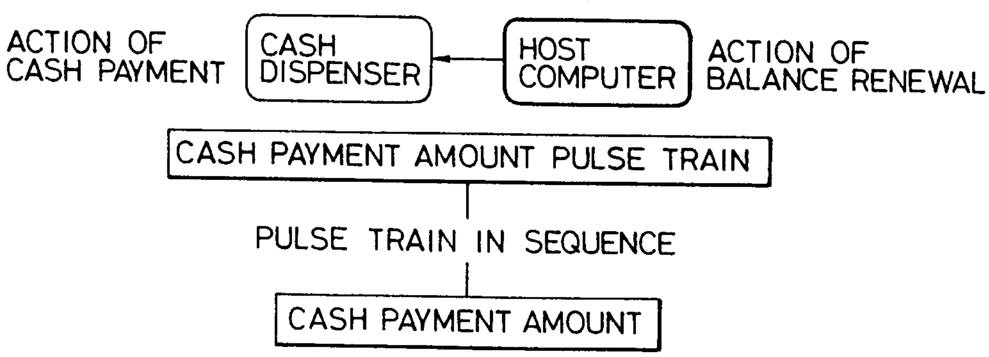

FIG. 16(a)

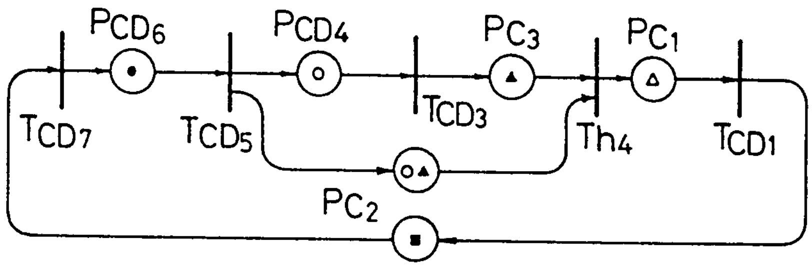


FIG. 16(b)

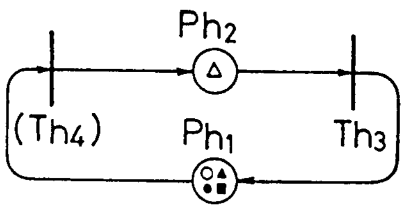


● : INITIAL POSITION
○ : 1st POSITION
▲ : 2nd POSITION
△ : 3rd POSITION
■ : 4th POSITION

FIG. 16(c)

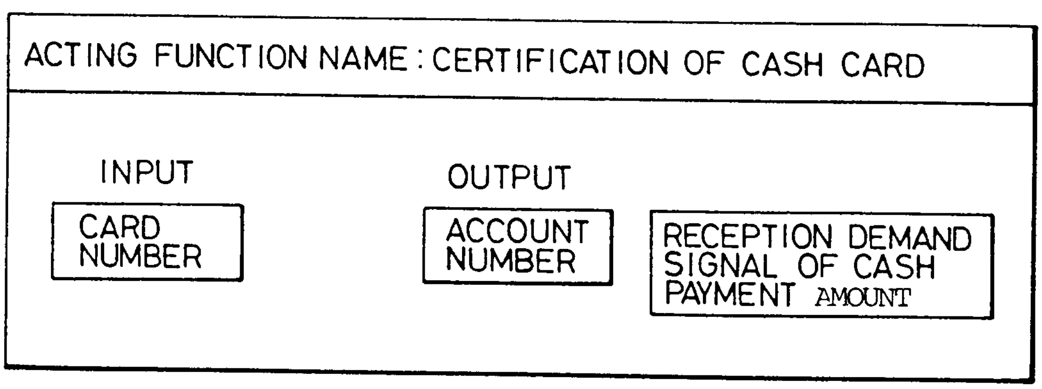

FIG. 17A

| CASH DISPENSER | | FLAG WHICH DISTINGUISHES IF THE PRESENT STEP IS IN THE STEP OF TOKEN (5h SHOWN IN FIG. 12 CHANGES AS FOLLOWS) | | | | |
|---|---|---|---|---|---|---|
| PLACE NAME | DATA STRUCTURE NAME | INITIAL SITUATION | 1st SITUATION | 2nd SITUATION | 3ed SITUATION | 4th SITUATION |
| $P_{CD_6}$ | CARD NUMBER | 1 | 0 | 0 | 0 | 0 |
| $P_{CD_4}$ | RECEPTION DEMAND SIGNAL OF CASH PAYMENT AMOUNT | 0 | 1 | 0 | 0 | 0 |
| $P_{C_3}$ | CASH PAYMENT AMOUNT | 0 | 0 | 1 | 0 | 0 |
| $P_{C_2}$ | ACCOUNT NUMBER | 0 | 1 | 1 | 0 | 0 |
| $P_{C_1}$ | CASH PAYMENT AMOUNT | 0 | 0 | 0 | 1 | 0 |
| $P_{CD_2}$ | CARD RECEPTION DEMAND | 0 | 0 | 0 | 0 | 1 |

FIG. 17B

| HOST COMPUTER | | FLAG WHICH DISTINGUISHES IF THE PRESENT STEP IS IN THE STEP OF TOKEN (5h SHOWN IN FIG. 12 CHANGES AS FOLLOWS) | | | | |
|---|---|---|---|---|---|---|
| PLACE NAME | DATA STRUCTURE NAME | INITIAL SITUATION | 1st SITUATION | 2nd SITUATION | 3ed SITUATION | 4th SITUATION |
| $P_{h_2}$ | ENTRY DATA | 0 | 0 | 0 | 1 | 0 |
| $P_{h_1}$ | BALANCE | 1 | 1 | 1 | 0 | 1 |